# EUROPEAN PATENT APPLICATION

(11) **EP 4 597 125 A1**
(43) Date of publication of application: **06.08.2025**
(21) Application number: 24155004.5
(22) Date of filing: 31.01.2024
(51) Int. Cl.: G01R 27/26, G01R 27/28

(54) **APPARATUS FOR DETERMINING PARAMETERS OF AN ELECTRONIC DEVICE**

(71) Applicant: HENSOLDT Sensors GmbH, 82024 Taufkirchen (DE)
(72) Inventor: Béquart, Jean-Christophe, 89079 Ulm (DE); Böhm, Dennis, 89073 Ulm (DE)
(74) Representative: LifeTech IP Spies & Behrndt Patentanwälte PartG mbB

(57) **Abstract**

Disclosed is an apparatus (100) for determining parameters of an electronic device (10) by means of a vector network analyzer (20). The electronic device (10) is designed for a radar system and configured to be set in any one of a plurality of states. The vector network analyzer (20) is configured to run a test of the electronic device (10). The apparatus (100) comprises a device controller (no), configured to set a state of the electronic device (10), an analyzer controller (120), configured to send to the vector network analyzer (20) a test trigger signal (125) for triggering the test of the electronic device (10), and a determination controller (130), configured to determine the parameters based on setting the state of the electronic device (10), and on triggering the test of the electronic device (10).

## Description

The present invention relates to an apparatus and a method for determining parameters of an electronic device by means of a vector network analyzer, and in particular to enhanced fast mode measurements for automatic active RF component characterization using advanced triggering interaction between a vector network analyzer and a device-under-test controller.

### BACKGROUND

In the state of the art it is known to determine functional parameters of an electronic device by applying test inputs and studying the reactions. A determination of functional parameters may be performed, for example, in a context of manufacturing or a maintenance of the device, or for acquiring an understanding of how the electronic device works.

Besides well-established methodology, a variety of instruments for performing such a determination are known. Very generally, two properties are desirable in a testing instrument: On the one hand, it should be adapted to run tests efficiently and in reasonable time on the often very complex electronic devices which can exhibit a large number of operational states. Generically, this requires the instrument to have a specific architecture, depending on the type of electronic devices to be tested. On the other hand, the same instrument should be employable for broad ranges of electronic devices.

Tests which have to be run repeatedly or for many settings of an electronic device can be automated by connecting both the electronic device and the measuring instrument to a computer. Running the tests is based on an input-output library, which is a collection of data utilities to connect to and configure the measuring instrument. An example of such a library is the virtual instrument software architecture, VISA, which provides a standard application programming interface for communication between the measuring instrument and the computer. The input-output library is employed for instructing the instrument to perform some operation, then waiting for a notification signaling that the operation is complete. For these tasks, the libraries usually provide a mechanism to perform a status request handling, SRQ, which is a protocol to retrieve information from the status registers in an instrument. Furthermore, an event handler is typically installed, which reacts to the notification from the measuring instrument and in turn relays the required data to the associated deferred processing handler.

However, for an electronic device exhibiting thousands of states, the accumulated time for performing the automated tests can make the parameter determination unfeasible.

Radar systems comprise one or more antennas for transmitting or receiving electromagnetic radiation, and equipment for generating and interpreting signals carried by the radiation. The equipment may comprise a transmit/receive module combining a duplexer, power amplifiers, phase shifters and further components for receiving and transmitting signals via radar. Further equipment may comprise signal generators, analog-to-digital converters, and means for signal processing, and for detecting, localizing and tracking objects. Such equipment thus generally comprises many electronic devices operating in the radio frequency, RF, range, and each can have a large number of possible states.

There are some arrangements which are customized for automated tests of particular electronic devices. For example, an arrangement is known for testing an efficiency of power amplifiers comprising a vector-signal transceiver for sending a test signal to the power amplifier, and a source measure unit together with an input-output library for pulsed RF measurements. While this arrangement can reduce the time for an individual test, and can be configured to run through states of a power amplifier automatically, it is specifically adapted to power amplifiers, and cannot easily be used for other types of electronic devices.

For thoroughly testing equipment of radar systems, the problem that thus even automated tests take a very long time can be particularly acute. Therefore there is a demand for speeding up test processes for radar systems in an efficient and reliable way.

### SUMMARY OF THE INVENTION

At least some of the above-mentioned problems are solved by an apparatus for determining parameters of an electronic device according to claim 1, a testing system according to claim 13, and a corresponding method according to claim 14. The dependent claims refer to further advantageous realizations for the subject matter of the independent claims.

The present invention relates to an apparatus for determining parameters of an electronic device by means of a vector network analyzer, wherein the electronic device is designed in particular for a transmission-reception chain of a radar system and configured to be set in any one of a plurality of states, and wherein the vector network analyzer is configured to run a test of the electronic device. The apparatus comprises a device controller, configured to be connected to and to set a state of the electronic device. The apparatus further comprises an analyzer controller, configured to be connected to the vector network analyzer and to send to the vector network analyzer a test trigger signal for triggering the test of the electronic device. The apparatus further comprises a determination controller, configured to determine the parameters based on setting the state of the electronic device by means of the device controller, and on triggering the test of the electronic device by means of the analyzer controller.

It is understood that the vector network analyzer itself is not a part of the apparatus; rather, the vector network analyzer may be a conventional such instrument. It is thus configured to run tests for measuring amplitude and phase properties in a large variety of radio frequency, RF, electronic devices. In embodiments, the vector network analyzer comprises a test set for providing a test signal to the electronic device and for receiving a reflection and transmission of the test signal. It may also comprise two or more receivers for measuring phase and magnitude of the test signal, the reflection, and/or the transmission. It may further comprise a processor and display or output for interpreting test results. The vector network analyzer may furthermore include a signal generator for generating or modifying the test signal, although the test signal may also be generated in some external source. Such a signal generator or external source may be configured to produce a continuous wave test signal of variable frequency, and the vector network analyzer or an external modulator may be configured to modulate or to adapt a level or magnitude of the test signal before the test signal is provided to the electronic device.

The vector network analyzer comprises means for its control by external devices. Such means in particular include an input port for the test trigger signal. It is known in the state of the art to connect the conventional vector network analyzer to a computer, and to run the test by software on that computer. Conventional vector network analyzers typically have the capability of using various trigger handshake mechanisms to interact with external devices.

The analyzer controller comprises an interface for connecting the apparatus to the vector network analyzer. This interface may be adapted to employ the conventional means, in particular input sockets and ports, of the vector network analyzer, stipulated for a control of the vector network analyzer.

The device controller comprises an interface for connecting the apparatus to the electronic device. The device controller may be configured to set the state of the electronic device based on data stored in an electronic memory of the apparatus or of some external device that the apparatus can be connected to. For setting the state of the electronic device, the device controller may comprise a means to control a DC electric current provided to the electronic device and/or a digital control interface to the electronic device. The current may e.g. be provided for setting a bias for the electronic device.

In advantageous embodiments, the apparatus, and in particular the device controller, the analyzer controller and the determination controller, are configured to determine the parameters by interacting with the vector network analyzer and with the electronic device on a hardware and/or firmware level, rather than on a software level.

The term software may be understood as application software, i.e. as instructions for a computer to perform functions beyond a basic operation of the computer itself. Software may run on top of an operating system, i.e. be entirely based on functions and routines provided by the operating system. Software thus inherits a latency of the operating system. A feature of software may be to provide a means for user interaction, i.e. for input from a user to the computer, or for output from the computer to the user. The expression "a software" may in particular refer to a software application, software program, or set of software programs.

In contrast, an operating system is understood to be entirely based on top of firmware of the respective computer. Thus, firmware may be understood as instructions for the apparatus or its components to perform respective basic operations. Firmware is generally not designed for user interaction, and may instead be "hidden" on the respective component.

The device controller, the analyzer controller and the determination controller comprise hardware and associated firmware configured to achieve a synchronization with the vector network analyzer. The configuration of the apparatus is thus based on the insight that rather than providing a dedicated measuring arrangement for some particular type of electronic device, and rather than operating the vector network analyzer as a particular measuring instrument by software on a computer, efficiency and speed of the determination of parameters can be improved by bypassing an operating system and software and merely using hardware and/or firmware for setting the state of the electronic device and operating the vector network analyzer. The apparatus exploits the advanced trigger capabilities of the network analyzer to perform its own synchronization. It then uses its internal hardware capabilities to derive the required timing signals required for controlling the electronic devices and perform the AC/DC current data acquisition.

The vector network analyzer may still require an initial setup by conventional software on a computer, but after the initial setup, the process of determining the parameters may be prepared and initiated exclusively by (or via) the apparatus.

The apparatus may be embodied as a single device, and the device controller, the analyzer controller and the determination controller may be included within a common housing. However, the device controller, the analyzer controller and the determination controller may be carried out as separate devices with appropriate data and power connections. In embodiments, the device controller includes a complex programmable logic device, a pulse modulator, and a bias circuit, and the determination controller and the analyzer controller are combined in a digital signal controller, which may comprise a rapid access memory for data storage.

The person skilled in the art will appreciate that features or properties described herein for any one of the controllers may also be carried out by another controller. In some embodiments, a controller may be composed of several parts, wherein each part is configured to provide some of the functions or properties described for the respective controller. However, the device controller, the analyzer controller and the determination controller may also be partially or fully integrated into each other.

Optionally the determination controller is configured to determine the parameters based on running a sequence of tests. The apparatus may employ a database or list of states and tests for the particular electronic device. The list may be provided from a computer or other user interface device, or may be stored in an electronic memory included in the apparatus. Advantageously, once initiated the sequence of tests is performed by the apparatus without user interaction or further input from software on a computer.

Optionally the apparatus is configured to be connected to a user interface device such as a computer, wherein the user interface comprises a user interface for a user to enter commands, and the determination controller is configured to receive from the user interface device an initiation signal for determining the parameters. The initiation signal may include or imply a sequence of tests that is to be performed. The connection to the user interface device may provide an interface between firmware on the apparatus, and an operating system and software on the user interface device. The determination controller may be configured to send to the user interface device a message including information about the parameters of the electronic device. The message may be sent after completion of the test or test sequence, or of the determination, without further synchronization to processes in the vector network analyzer and/or electronic device.

In embodiments, the user interface device is configured with a software for handling the vector network analyzer and the apparatus. Any conventional software adapted to control the vector network analyzer may be used. The software may provide at least one of the functions of loading data into a memory of the apparatus and/or of the vector network analyzer, configuring the apparatus and the vector network analyzer, starting a measurement, i.e. the test in particular, a sequence of tests, or the determination of parameters as a whole, and waiting for measurement trigger completion. Once the measurement is started, the apparatus and the vector network analyzer may automatically generate all required trigger signals for performing the measurement. No further handling of running the test, and in particular no further synchronization with the vector network analyzer, is required from the software. In advantageous embodiments, the software on the user interface device thus does not implement, or is not required to implement, synchronization handling during the measurement. In this way, a dependency of a measurement speed on a latency of the operating system on the user interface device is avoided.

Optionally, the apparatus is configured to set a state of one of the following electronic devices, or types of electronic devices: a power amplifier, a low-noise amplifier, an electronic attenuator, a phase shifter, or a duplexer. The apparatus may also be adapted for more complex arrangements of electronic components, in particular for a transmission and/or reception module. These electronic devices typically operate with signals in the RF range, and are common in radar systems. There are conventional vector network analyzers configured to run tests of one or more of these electronic devices. For each electronic device type, the determination controller may comprise or have access to an associated test scheme, which may comprise instructions for the apparatus how to recognize and communicate with a respective electronic device, and how to perform tests. The apparatus may be configured to let a user select the electronic device via the connection to the user interface device.

Conventional vector network analyzers often provide tests of a "one point" type, which are based on a test signal characterized by a single frequency and/or power level, or of a "sweep" type, where the test signal is characterized by a range of frequencies and/or power levels asserted consecutively over a certain time.

Optionally the analyzer controller is configured to adapt the test trigger signal to trigger at least one of these tests, namely, a point test, wherein the vector network analyzer runs a test characterized by one particular AC current frequency and/or one particular power, and/or a sweep test, wherein the vector network analyzer runs a test characterized by a particular range of AC current frequencies and/or a particular range of powers. The sweep test may be a segmented sweep, in which an arbitrary stimulus (e.g., arbitrary initial and final values for the range of frequency and/or power) can be generated.

Optionally, the analyzer controller is configured to send to the vector network analyzer setup information for the test. This setup information may be conveyed before the test is run, or during the test. The setup information may include information for configuring a state of the vector network analyzer such as an opening of ports, setting a trigger mode of the vector network analyzer, or arming a trigger. The setup information may serve to program stimuli, and may comprise information such as ranges or values for frequencies or power levels to be used in the test.

In addition, or alternatively, the analyzer controller may be configured to receive from the vector network analyzer a signal once the vector network analyzer is ready to run the test.

In addition, or alternatively, the analyzer controller may be configured to send to the vector network analyzer a signal for interrupting and/or resuming the running test. This can in particular be implemented if the analyzer controller is configured to receive information gathered and conveyed by the vector network analyzer which must first be processed in the apparatus.

In addition, or alternatively, the analyzer controller may be configured to receive from the vector network analyzer a status information about the running test. This may include e.g. information that the vector network analyzer is busy with some task, and not ready for accepting further control from the analyzer component.

In addition, or alternatively, the analyzer controller may be configured to receive from the vector network analyzer a confirmation signal for confirming that the vector network analyzer has terminated running the test. The apparatus may be configured to relay this information to the user interface device.

In addition, or alternatively, the analyzer controller may be configured to receive from the vector network analyzer result data pertaining to the test after the vector network analyzer has terminated running the test.

All aforementioned information or data can be included in signals or triggers which also serve for other purposes. Conventional vector network analyzers however often comprise two or more ports for handling signals or triggers, and the analyzer controller may be configured to connect to several ports.

Optionally, the analyzer controller is configured to receive from the vector network analyzer an analog electric pulse, to perform a sampling of the pulse, and to store data obtained from sampling of the pulse.

The pulse may be intended for the electronic device. The pulse may originate from outside the vector network analyzer, i.e. from a different source, but the vector network analyzer will in general be configured to receive and/or interpret the pulse, such that the apparatus may receive the pulse via the vector network analyzer. The analyzer controller may comprise an analog-to-digital converter configured to perform the sampling, and a direct memory access buffer for storing the data temporarily. The apparatus may also comprise rapid access memory for storing the data over a longer period of time. An interface may be included in the apparatus for retrieving the data from the memory. The apparatus may comprise a processor device configured to perform further data processing of the data stored in the memory.

Upon connection to a vector network analyzer, the determination controller may be configured to let the analyzer controller go automatically through all available pulses. The determination controller may also be configured to admit this upon a request of a user.

Optionally, for the test an analog electric pulse is provided to the electronic device, and the device controller is configured to modulate the pulse before it is provided to the electronic device.

Optionally, the apparatus is configured to measure a direct current parameter of the electronic device. This may include a test where a direct current is provided to the electronic device. The direct current may be provided as one or more analog electric pulses, which the apparatus may be configured to handle as described before. The apparatus may be configured to interrupt or suspend the running test in the vector network analyzer for processing received pulses.

Optionally, the determination controller and/or the analyzer controller is configured to initiate a calibration by the vector network analyzer, and to wait for its completion. The calibration may serve to setup the vector network analyzer for the test. The calibration may e.g. comprise a pre-sweep before a sweep test. The apparatus may be configured to initiate a pre-sweep in particular if automatic level control functions of the vector network analyzer are at risk of not working properly, such as e.g. for tests based on high frequencies. The apparatus may be configured to initiate the calibration in a DC test or measurement.

Optionally, the determination controller is configured to detect a type of the electronic device, e.g. upon connecting the apparatus with the electronic device via the device controller. The apparatus may store a list for detecting the type of the electronic device. The list may comprise instructions for reference signals to be sent and received via the device controller for detecting the type of the electronic device.

Optionally, the apparatus includes a user interface for a user to set the state of the electronic device. The apparatus may thus be configured to operate as a standalone device for manual measurements of the electronic device.

Embodiments further refer to a testing system for determining parameters of an electronic device, wherein the electronic device is designed for a transmission-reception chain of a radar system and configured to be set in any one of a plurality of states. The testing system comprises a vector network analyzer, configured to run a test of the electronic device, an apparatus as disclosed above, and a user interface device, configured to setup the vector network analyzer, and to connect to the apparatus. The user interface device may e.g. be a computer, and may run a software configured to admit a user request for the determination of the parameters of the electronic device.

Embodiments further refer to a method for performing a measurement of parameters of an electronic device by means of a vector network analyzer, wherein the electronic device is designed for a transmission-reception chain of a radar system and configured to be set in any one of a plurality of states, and wherein the vector network analyzer is configured to run a test of the electronic device.

The method comprises setting a state of the electronic device, sending to the vector network analyzer a trigger signal configured to trigger the test of the electronic device and determining the parameters based on setting the state of the electronic device, and on triggering the test of the electronic device. In advantageous embodiments, all steps carried out on the vector network analyzer, in particular sending the trigger signal, as well as setting the state of the electronic device and determining the parameters are carried out on a hardware and/or firmware level rather than on a software level, e.g. by means of an apparatus as described above.

Aspects of advantageous embodiments of the apparatus and method can be summarized as follows.

The apparatus is configured to control the vector network analyzer for running tests on the electronic device. The apparatus may be based on a digital signal controller running its associated firmware. In advantageous embodiments, the apparatus is configured to process all synchronization signals from the vector network analyzer (such as trigger or pulse generators), and to take the appropriate action (such as module control, data acquisition, and triggering).

To achieve this, the vector network analyzer and the apparatus may be configured to be set up by a test software on a user interface device, such as a computer. Based on the test software, the vector network analyzer is set up for the desired measurement (e. g power measurement, or noise figure), then programmed for the actual stimuli (e. g segmented sweep for arbitrary frequency or power stimulus); finally, a trigger mode may be configured. At this point, the apparatus is set-up: settings memory is loaded, and then the actual measurement is launched. The controller and the vector network analyzer subsequently interact with each other (bi-directionally) without any test software intervention. The hardware/firmware-based interaction provides a real-time control of the measurement. As soon as the measurement is complete, a calling application comprised in the test software on the user interface device may be asynchronously notified by a message from the apparatus.

Taking advantage of the real-time capabilities of the apparatus, the measurement runs at a maximal speed permitted by the vector network analyzer. As soon as the vector network analyzer has completed a measurement, it notifies the apparatus by means of a trigger signal. In turn, the apparatus sets the next state of the electronic device based on a settings memory, and then triggers the next vector network analyzer measurement.

For direct current, DC, data acquisition, the apparatus may be configured to apply a nested triggering. Some vector network analyzers can supply auxiliary trigger pairs, additionally to the main (measurement) trigger pair, and also provide the required handshake functionality. The apparatus and method take advantage of this capability, that is, when the vector network analyzer has set its stimulus, the apparatus sends an auxiliary trigger signal to the controller, which in turn sets the corresponding state of the electronic device as described before, then performs the DC acquisition, and finally sends back an auxiliary trigger signal to the vector network analyzer on acquisition completion. At this point, the actual RF measurement takes place, the vector network analyzer moves to the next stimulus point, and the process is repeated until the measurement is complete.

The apparatus and method provide a measurement routine offering control of the electronic device (e.g. for setting a transmit-receive module state, or an amplifier bias), real-time triggering interaction with the vector network analyzer, and an acquisition of the DC parameters (such as power amplifier pulsed drain/gate currents).

From the test software point of view, the functionality is provided by a set of three functions: loading data into memory, configuring and starting the measurement, and waiting for measurement trigger completion. Once started, the apparatus provides an enhanced fast measurement mode that will automatically generate and handle all required triggers and signals within a set of measurements, removing the need to implement synchronization handling in the test software. This can remove a dependency between the measurement speed and the operating system latency present in conventional automation setups.

Advantages of the disclosed apparatus and method include that a latency of an operating system used for conventional automation of the vector network analyzer is bypassed, while the apparatus can still, via the vector network analyzer, be employed for testing a broad range of RF electronic devices. The apparatus thus exploits the versatility of a vector network analyzer, but allows a very high speed of execution of tests for determining the parameters. The apparatus and method thus solve the problem of measuring complex electronic devices, such as a transmit-receive module, that can exhibit many thousands of different states. In embodiments it is possible to measure up to 64 thousand module states in one vector network analyzer sweep, hereby varying the stimulus (frequency, power) and also the state of the electronic device for each point in the sweep. Consequently, the apparatus offers the possibility to fully characterize a T/R module in very little time, thus maximizing production throughput. The apparatus and method are usable for various kinds of measurements, such as gain, noise figure, or output power. Generally, the apparatus and the method can be used in a laboratory environment (e.g. for component evaluation and characterization), as well as in a production environment (e.g. for automatic volume testing).

### BRIEF DESCRIPTION OF THE DRAWINGS

Various embodiments of the present invention will be described in the following by way of examples only, and with respect to the accompanying drawings, in which:
- Fig. 1: shows an apparatus for determining parameters of an electronic device by means of a vector network analyzer according to the pre-sent invention.
- Fig. 2: shows further details of an embodiment of the apparatus.
- Fig. 3: illustrates functions of the apparatus.
- Fig. 4: illustrates further functions of the apparatus.
- Fig. 5: illustrates functions of the apparatus for a DC measurement.
- Fig. 6: illustrates further functions of the apparatus for a DC measurement.
- Fig. 7: shows steps of a method according to the present invention.
- Fig. 8: shows further steps of an embodiment of the method.
- Fig. 9: shows an embodiment of the method including a DC measurement.

### DETAILED DESCRIPTION

Various examples will now be described more fully with reference to the accompanying drawings in which some examples are illustrated. It should be understood that there is no intent to limit examples to the particular forms disclosed, but on the contrary, examples are to cover all modifications, equivalents, and alternatives falling within the scope of the disclosure as defined by the subsequent claims and the description.

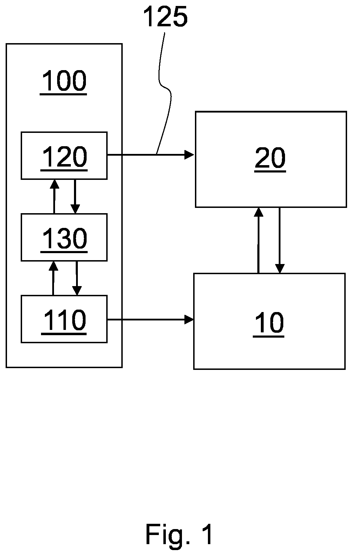

**Fig. 1** shows an embodiment of an apparatus 100 for determining parameters of an electronic device 10 by means of a vector network analyzer 20. The electronic device 10 may be referred to as the device under test, DUT. The electronic device 10 is designed for a radar system (not shown), and configured to be set in any one of a plurality of states. The vector network analyzer 20 is configured to run a test of the electronic device 10. The apparatus 100 comprises a device controller 110, configured to set a state of the electronic device 10, an analyzer controller 120, configured to send to the vector network analyzer 20 a test trigger signal 125 for triggering the test of the electronic device 10, and a determination controller 130, configured to determine the parameters based on setting the state of the electronic device 10, and on triggering the test of the electronic device 10. The apparatus 100, and in particular the device controller 110, the analyzer controller 120 and the determination controller 130, are configured to determine the parameters by interacting with the vector network analyzer 20 on a hardware and firmware level, rather than on a software level.

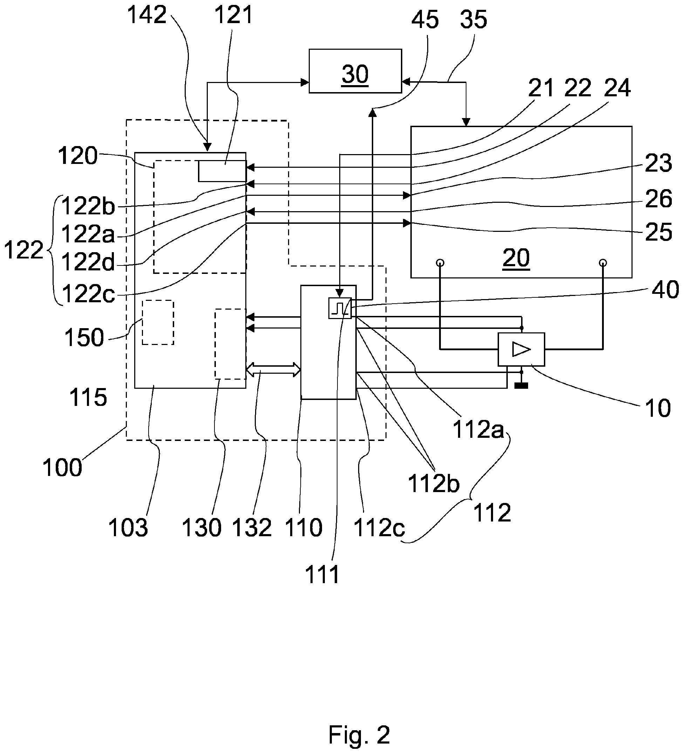

**Fig. 2** shows further details of an embodiment of the apparatus 100. The vector network analyzer 20 is connected to the electronic device 10, which here is an exemplary power amplifier. The apparatus 100 is based on a digital signal controller 103 and associated peripherals. In particular, the device controller 110 comprises an access interface 112 for the electronic device 10, the analyzer controller 120 comprises a trigger interface 122, and the apparatus 100 comprises a USB port 142 for external control or firmware update by software installed on a computer 30. The digital control part of the access interface functionality is realized in a complex programming logic device, CPLD. The apparatus 100 is furthermore equipped with additional rapid access memory, RAM 150, for data storage. The computer 30 is configured to control an initial setup of the vector network analyzer 20 via a local area network connection 35.

The apparatus 100 may be equipped with a touch screen, and may be configured for being used as standalone device, e. g. for manual measurements of the electronic device 10. The apparatus 100 is configured to be remote-controlled over the USB port 142, hereby giving access to the trigger and data acquisition functionality.

The firmware itself has the capability to autodetect the connected electronic device 10 (provided it is a known device, i.e. listed in some database either stored on the apparatus 100, or retrieved e.g. from the computer 30), and provides that particular control functionality of the electronic device 10.

The device controller 110 is realized as a signal conditioning or measurement board. The board 110 may be referred to as analog front-end of the apparatus 100. The board 110 comprises a connection 111 for providing a current for modulating analog electronic pulses, provided by a first pulse output 21 of the vector network analyzer 20. The current connection 111 employs an exterior voltage source 45. The board 110 comprises a connection 112a for providing a bias current to the electronic device 10. The board 110 comprises connections 112b for sensing a voltage difference at the electronic device 10, and a gate drive connection 112c. The board 110 contains drive electronics (in particular, pulse modulator and bias circuitry, not shown) needed for measurements of the exemplary power amplifier 10. The board 110 comprises two analog connections 115 for current and voltage to the digital signal controller 103. The board 110 is configured to be controlled and to exchange power over a connection 132 with the digital signal controller, such that a bias can be electronically adjusted by the determination controller 130. The board 110 is also equipped with current measurement circuitry for drain and gate pulse current, providing the signal conditioning interface for inputs to an analog-to-digital converter 121. The board is also equipped with an electrically erasable programmable read-only memory, EEPROM, containing calibration data of the board (not shown).

The trigger interface 122 comprises several trigger signal ports.

A first port 122a is connected to a conventional "measurement trigger in" port 23 of the vector network analyzer 20. Depending on the setup of the vector network analyzer 20, the vector network analyzer 20 may initiate running a test after receiving a signal over this connection. The apparatus 100 may thus send the test trigger signal 125, and/or information on the setup of the test, via the first port 122a. A second port 122b is connected to a "measurement trigger ready" port 24 of the vector network analyzer 20. The vector network analyzer 20 can be configured to send a trigger signal over this connection if the vector network analyzer 20 is ready to run the test.

As a main use case where the test trigger signal 125 is conveyed over the first port 122a, the vector network analyzer 20 may be configured to run an RF test upon receiving the test trigger signal. The test trigger may be a single event trigger, with deferred processing capability. The apparatus 100 may be configured for auto-retriggering when the vector network analyzer 20 signals that it is in a busy state.

A third port 122c and a fourth port 122c are connected to an "auxiliary trigger in" port 25 and an "auxiliary trigger out" port 26 of the vector network analyzer 20, respectively. The apparatus 100 may be configured to send to the vector network analyzer 20 a signal for interrupting and/or resuming the running test via the third port 122c, and to receive from the vector network analyzer 20 a status information about the running test via the fourth port 122d. Such auxiliary triggers may be exchanged e.g. for data acquisition in DC tests. A wait for device handshake capability of the vector network analyzer 20 may be employed to send or receive from the vector network analyzer 20 signals for interrupting and/or resuming the running test. In particular, the apparatus 100 may be configured to send a signal to interrupt the running test e.g. if the apparatus 100 has to process data from the test. The vector network analyzer 20 interrupts its processing and in turn sends an auxiliary trigger signal to the apparatus 100. The apparatus 100 may be configured to send back an auxiliary trigger to the vector network analyzer 20 once the apparatus 100 has completed its processing, upon which the vector network analyzer 20 resumes its action. The auxiliary trigger may be handled as single event trigger if busy handling is not necessary.

The analyzer controller 120 further comprises an exemplary four-input analog-to-digital converter, ADC 121. The ADC 121 is configured to receive analog electric pulses from or via the vector network analyzer 20. Each of the four inputs of the ADC 121 is equipped with its own sample and hold function. After setup of the apparatus 100, the analyzer controller 120 is configured to acquire pulses at the same time for all inputs, before the ADC 121 converts the data sequentially and places the result in a buffer memory (not shown) using scatter-gather direct memory access, DMA.

The apparatus 100 may be configured to check all available pulses that can be generated by or routed via the vector network analyzer 20, and to measure a pulse width for each pulse. The apparatus 100 may be configured to perform this check and measurement when booting the apparatus 100, or at a request via software from the computer 30.

The apparatus 100 is further configured to transmit to the vector network analyzer 20 a DC trigger signal for initiating the run of a DC test. The apparatus 100 may be configured to derive the DC trigger signal from the previously measured pulse widths. The apparatus 100 may be configured to define an ADC acquisition window pulse, and to slice the ADC acquisition window pulse into an amount of points required to fill the DMA buffer memory. The acquisition may take place one time per pulse, wherein from one pulse to a next pulse, an acquisition point is shifted by one slice. The apparatus 100 may be configured to repeat this process until the acquisition point has walked over the whole pulse (equivalent time sampling), before generating, e.g. by a part of the apparatus 100 controlling the DMA, an interrupt, and copying the data into the RAM 150. The RAM 150 may for example be carried out as a dedicated SRAM, whose contents can be retrieved by the computer 30 over USB 142. The apparatus 100 may be configured to apply additional mathematical operations to the RAM data, such as an averaging function over the pulse width.

Pulses handled by the apparatus 100 may comprise a DC pulse adapted for switching a bias on or off, and to provide a modulation, an RF pulse adapted for source modulation of the vector network analyzer 20, and an ADC pulse, adapted for imposing on measuring pulses an ADC acquisition window.

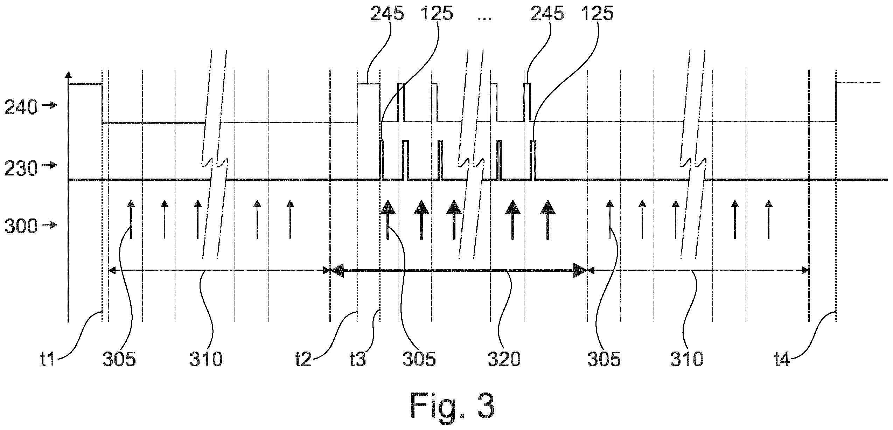

**Fig. 3** illustrates the functions of an embodiment of the apparatus 100 by means of signals and actions of the apparatus 100 and the vector network analyzer 20 in a chronological sequence, where the horizontal direction represents a time direction.

The figure shows the test trigger signal 125, sent by the analyzer controller 120 to the vector network analyzer 20, which in the present case is provided as a change in a "measurement trigger in" level 230 provided to a corresponding conventional port 23 of the vector network analyzer 20. The figure further shows a "measurement trigger ready" level 240, provided from a corresponding conventional port 24 of the vector network analyzer 20, by which signals are sent from the vector network analyzer 20 to the analyzer component 110. The figure also shows aspects of a vector network analyzer 20 data acquisition 300, which in the present case is for a "sweep" type test.

Assumed is a suitable configuration of the vector network analyzer 20. Conventional vector network analyzers 20 admit a mode where triggering is provided externally. For a determination of parameters as shown in this figure, the test trigger is set to point trigger. The vector network analyzer 20 may setup itself for the determination, in particular by preparing a first stimulus point.

Based on software in the user interface device, RAM arrays 150 of the apparatus 100 may be loaded with data pertaining to the determination. After this, an initiation signal, i.e. an initial execution command, may be sent from the user interface device 30 to the apparatus 100. The initiation signal may also configure a trigger count to match a sweep length, and an iteration count to match a segment count in case of a segmented sweep.

On reception of the initiation signal, the device controller 110 may change to an armed state. Depending on details of the intended determination of parameters, the following actions may occur:
- The apparatus 100 sets a first state of the electronic device 10 via the device controller 110 (not shown).
- At a first instance *t1*, the apparatus 100 arms a measurement trigger detection (single event) of the vector network analyzer 20. In the present case, the vector network analyzer 20 performs a background sweep 310 for internal calibration. The sweep 310 comprises a sequence of stimulus points characterized by an increasing frequency, as indicated by arrows 305 in the figure.
- At a second instance *t2*, the vector network analyzer 20 has completed the background sweep 310 and sends a signal 245 that it is ready to run the actual sequence of tests, here by having the measurement ready trigger asserting an active state.
- At a third instance *t3*, the apparatus 100 sends the test signal 125 via the measurement trigger in level 230. This commences the actual measurement sweep 320. A time elapsed between the second instance *t2* and the third instance *t3* can be very short, as the apparatus 100 and the vector network analyzer 20 merely interact on a hardware/firmware level, and thus avoid latencies induced by an operating system and the software e.g. in the user interface device 30.
- After having triggered the measurement sweep 320, the vector network analyzer 20 runs the test for each stimulus of the sweep 320, increasing the frequency from one stimulus to the next. At the completion of each test, the vector network analyzer 20 sends a signal 245 that it is ready to run the next test by means of the measurement ready trigger. Upon receiving this signal 245, the apparatus 100 in this example keeps the state of the electronic device 10, and resends the test signal 125 to the vector network analyzer 20 for performing the next test. The time until the test signal 125 is sent is again very short, due to the interaction of the apparatus 100 on the hardware/firmware level with the vector network analyzer 20.
- After running through the test sequence, the vector network analyzer 20 automatically performs a further background sweep 310 for calibration. At a fourth instance *t4,* the vector network analyzer 20 has completed the background sweep 310 and signals its readiness for a next test by means of the measurement ready trigger level 240.

In this example, the apparatus 100 prompts the vector network analyzer 20 only by means of the test trigger signal 125. The apparatus 100 may be configured to check a busy/ready state from the vector network analyzer 20, i.e. receive a status information from the vector network analyzer 20, by retrieving the level of the measurement ready trigger 240 e.g. when arming its detection mechanism (not shown).

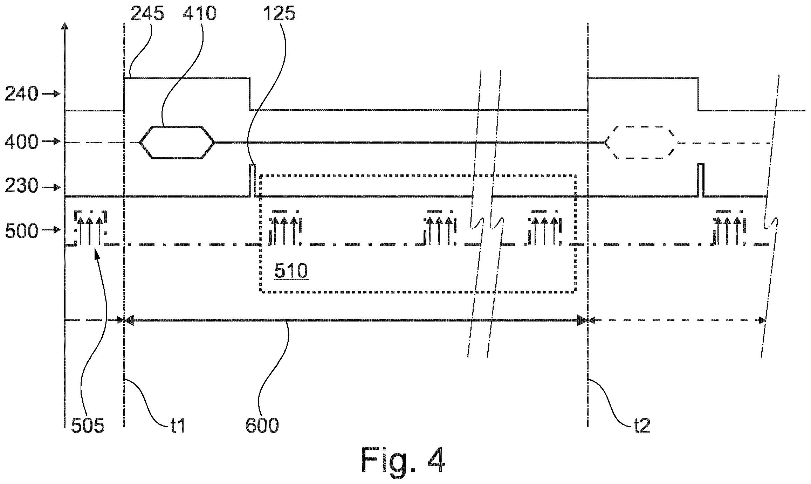

**Fig. 4** further illustrates the functions of the apparatus 100 by means of signals and actions of the apparatus 100 and the vector network analyzer 20 in a chronological sequence, where the horizontal direction represents a time direction.

The figure shows the test trigger signal 125 in a "measurement trigger in" level 230, and a "measurement trigger ready" level 240, similarly to Fig. 3. The figure also shows aspects of a data acquisition 500 in the vector network analyzer 20, here for a "point" type sequence of tests and based on RF pulses 505 provided to the electronic device 10. The figure furthermore shows a device command line 400 illustrating how the apparatus 100 sets a state of the electronic device 10. A time span 600 in which a particular frequency point (i.e., pulses 505 characterized by a particular frequency) is measured for the electronic device 10 is also indicated.

The figure shows a part of a sequence of tests. At a first instance *t1,* the vector network analyzer 20 sends the measurement trigger ready signal 245 to the apparatus 100 by setting the measurement trigger level 240 to a high value, and holds the data acquaintance. This prompts the apparatus 100 to provide a device command 410 to the electronic device 10 for setting a new state of the electronic device 10, characterized e.g. by a particular RF frequency. The apparatus 100 then sends the test trigger signal 125 to the vector network analyzer 20, which goes into a "busy" state by setting the measurement ready trigger level 240 to a low value, and performs a measurement 510, i.e., automatically measures a response of the electronic device 10 to some fixed number of pulses 505. After the acquisition 510, at a second instance *t2*, the cycle is repeated for a further state (e.g., a further RF frequency) of the electronic device 10.

As in Fig. 3, the apparatus 100 again prompts the vector network analyzer 20 only by means of the test trigger signal 125 via the measurement trigger in port 23.

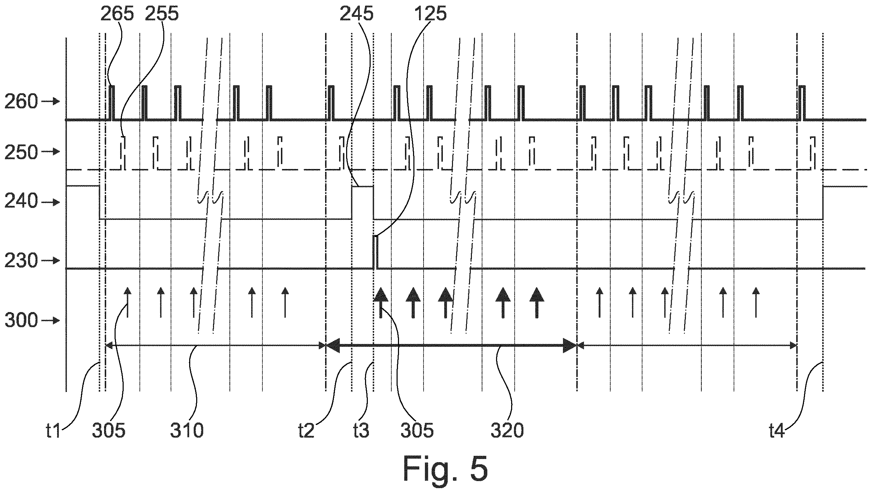

**Fig. 5** further illustrates the functions of the apparatus 100 by means of signals and actions of the apparatus 100 and the vector network analyzer 20 in a chronological sequence, where the horizontal direction represents a time direction.

The figure shows the measurement trigger in level 230 and the measurement trigger ready level 240, and aspects of a vector network analyzer 20 data acquisition 300 for a "sweep" type sequence of tests as described before for Fig. 3. The figure furthermore shows an "auxiliary trigger in" level 250 and an "auxiliary trigger out" level 260 at corresponding ports 25, 26 of the vector network analyzer 20. The auxiliary trigger may e.g. be employed for a determination of direct current, DC, parameters.

At the first instance, the auxiliary trigger of the vector network analyzer 20 is enabled, which may also happen by means of the software on the computer 30. For each stimulus in both the background sweeps 310 and the measurement sweep 320, the vector network analyzer 20 sends an auxiliary trigger signal 265 as a status information about the running test, namely that the respective stimulus point has been set. Upon detecting the auxiliary trigger signal 265, the apparatus 100 may set a state of the electronic device 10 (if this has not been done before) and initiate a DC acquisition (not shown). After the DC acquisition is completed, the apparatus 100 sends an auxiliary trigger signal 255 as a signal for resuming the running test, upon which the vector network analyzer 20 performs the actual RF measurement, and then moves to the next stimulus point.

A speed of the process is mainly determined by the speed at which the apparatus 100 handles the synchronization with the vector network analyzer 20 and the electronic device 10. The speed is improved compared to using a software to handle the vector network analyzer 20, since the apparatus 100 interacts both with the vector network analyzer 20 and with the electronic device on a hardware/firmware level, without any interference by the operating system or the software on the computer 30.

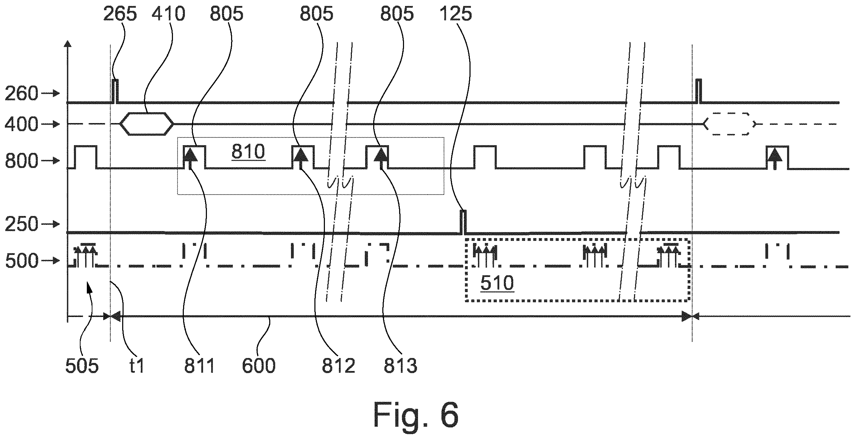

**Fig. 6** further illustrates the functions of the apparatus 100 by means of signals and actions of the apparatus 100 and the vector network analyzer 20 in a chronological sequence, where the horizontal direction represents a time direction.

The figure shows aspects of data acquisition 500 in the vector network analyzer 20 for a "point" type sequence of tests based on RF pulses 805 provided to the electronic device 10, and a device command line 400 illustrating how the apparatus 100 sets a state of the electronic device 10, as in Fig. 4.

The figure also shows an auxiliary trigger in level 250 and an auxiliary trigger out level 260, at respective auxiliary ports 25, 26 of the vector network analyzer 20. At a first instance *t1*, the vector network analyzer 20 sets itself to a stimulus characterized by a particular frequency. When this is done, the vector network analyzer 20 provides a status information to the apparatus 100 by sending a signal 265 over the auxiliary trigger out port 26. After receiving this signal 265, the apparatus 100 performs a setting 410 of a corresponding state of the electronic device 10.

The figure also shows a pulse current 800 at the apparatus 100, i.e. the pulses 805 provided to the electronic device 10 and received by the apparatus 100, e.g. via the vector network analyzer 20. The apparatus 100 may comprise an analog-to-digital converter 121 for receiving the pulses 805. The apparatus 100 is configured to perform, within a pulse current acquisition time window 810, a sampling of the pulses, and stores data obtained from the sampling. The apparatus 100 holds information about a pulse width and a slicing of the pulses 805 into an amount of slices 811, 812, 813 corresponding to a size of a buffer memory; the apparatus 100 may have acquired this information e.g. through a measurement of the pulses 805 at a beginning of the process of determining the parameters of the electronic device 10. The apparatus 100 is configured to sample the pulses 805 at one acquisition time per pulse 805, and to shift the acquisition time by one slice from one pulse 805 to the next, until the buffer memory is filled. At this point, the apparatus 100 interrupts the pulse current sampling 810 and transfers the content of the buffer memory to a rapid access memory 150, from which the data can asynchronously be retrieved by means of software in the computer 30.

Upon interrupting the pulse current acquisition 810, the apparatus 100 generates the test trigger signal 125, which here occurs over the "auxiliary trigger in" port 25 rather than over a "measurement trigger in" port 23. Upon receiving the trigger signal 125, the vector network analyzer 20 performs the data acquisition 510, similarly as described before for Fig. 4.

Due to interacting with the vector network analyzer 20 and the electronic device 10 on a hardware and/or firmware level, avoiding latencies of an operating system or a software, the apparatus 100 achieves a very efficient synchronization for the determination of the parameters. In embodiments, a time span for which the vector network analyzer 20 is set to one particular stimulus may be less than 5 ms. A pulse repetition interval may last less than 100 µs.

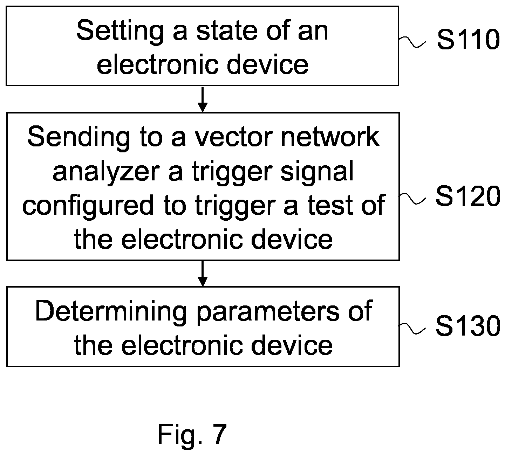

**Fig. 7** shows steps of a method for performing a measurement of parameters of an electronic device 10 by means of a vector network analyzer 20, wherein the electronic device 10 is designed for a transmission-reception chain of a radar system and configured to be set in any one of a plurality of states, and wherein the vector network analyzer 20 is configured to run a test of the electronic device 10. The method comprises setting S110 a state of the electronic device 10, sending S120 to the vector network analyzer 20 a test trigger signal 125 configured to trigger the test of the electronic device 10, and determining S130 the parameters based on setting S110 the state of the electronic device 10, and on triggering the test of the electronic device 10 on a hardware and/or firmware level, i.e. without being slowed down by latencies induced by an operating system or software.

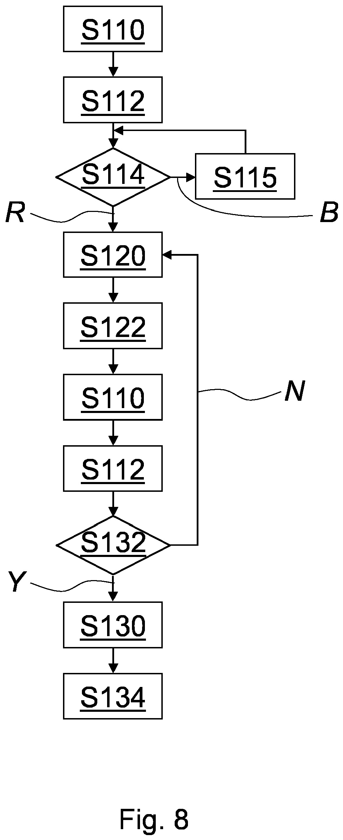

**Fig. 8** shows a particular embodiment of the method of determining parameters of the electronic device 10. This method may be understood as being carried out by the disclosed apparatus 100, i.e., embodiments of the apparatus 100 may be configured to carry out the method as described by means of the present figure.

As a prerequisite, it is assumed that after a suitable configuration of the vector network analyzer 20 where a measurement trigger is set to point trigger, and no auxiliary trigger is activated, the vector network analyzer 20 has set itself on a first stimulus point.

The method comprises setting S110 a first state of the electronic device 10, arming S112 the measurement ready trigger detection (single event), and checking S114 a busy/ready state of the vector network analyzer 20 by means of the measurement ready trigger signal.

In a ready case (R), the method comprises sending S120 the test trigger signal 125 to the vector network analyzer 20, which in turn performs the RF measurement, moves to a next stimulus point, and sends out a measurement ready trigger signal 245.

The method then comprises detecting S122 the measurement ready trigger before setting S110 a next state of the electronic device 10 and again arming S112 the measurement trigger detection.

The method then comprises checking S132 if all required states of the electronic device 10 have been tested. If this is the case (*Y*), determining S130 the parameters has been completed, which may be made manifest by sending S134 a suitable notification and/or data to a software. If not all required states have been tested, the method loops back to sending the test trigger signal.

In a busy case (B), the method comprises waiting S115, for a certain period of time, for the measurement ready trigger signal before looping back to checking S114 the busy/ready state.

This embodiment of the method is advantageous for determining parameters of a transmit-receive module. The method may be employed for a functional test or a characterization of the full module or of a particular part of the module, such as an attenuator and/or phase shifter (where the method may involve one segmented sweep for both components). The method may also be employed for measurements where a target value has to be adjusted over the frequency range of the sweeps, e.g. by adjusting the attenuator for each point. Here the method can be adapted to any conventional measurement type (e.g. gain, noise figure, or output power).

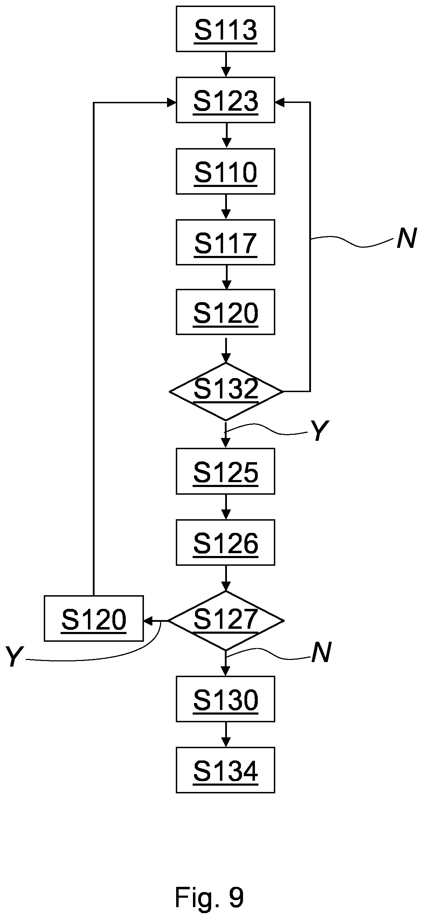

**Fig. 9** shows a further embodiment of the method of determining parameters, in particular DC parameters, of the electronic device 10. This method may be understood as being carried out by the disclosed apparatus 100, i.e., embodiments of the apparatus 100 may be configured to carry out the method as described by means of the present figure.

Prerequisites are analogous to those described for Fig. 8, with the exception that here an auxiliary trigger of the vector network analyzer 20 is activated.

The method comprises arming S113 both a main (measurement) and the auxiliary trigger detection of the vector network analyzer 20. The vector network analyzer 20 may reset its sweep, set a first stimulus point, and then send out an auxiliary trigger signal 265.

The method comprises detecting S123 the auxiliary trigger signal 265, setting S110 a state for the electronic device 10, and initiating S117 a DC acquisition.

The DC acquisition may comprise receiving a pulse which has been routed through the electronic device 10, and may e.g. be received via the vector network analyzer 20. The DC acquisition may further comprise measuring a set of one or more sample points in the pulse and saving an outcome to a buffer memory. The DC acquisition may comprise checking if the buffer memory is full, or if a predefined amount of sample data has been acquired. If this is the case, the method may comprise interrupting the DC acquisition. If not, the method may comprise shifting the set of sampling points, and looping to receiving a next pulse.

On DC acquisition completion, the method comprises sending S120 an auxiliary trigger signal as the test trigger signal 125 to the vector network analyzer 20, which then performs the actual RF measurement, moves to a next stimulus point and sends out an auxiliary trigger signal 265.

The method then comprises checking S132 if a state array has been fully processed, i.e. if all required states of the electronic device 10 have been tested. If not all required states have been tested (*N*), the method loops back to detecting S123 the auxiliary trigger signal 265 just sent by the vector network analyzer 20.

If all required states have been tested (*Y*), the method comprises waiting S125 for a measurement ready trigger signal 245 from the vector network analyzer 20, and, upon receiving S126 the measurement ready trigger signal 245, checking S127 if only a first sweep (i.e., a background sweep 310 for a calibration of the vector network analyzer 20) has been performed. This checking S127 may be based on a sweep counter stored and updated in the apparatus 100. If the outcome is positive (*Y*), the method comprises sending S120 a measurement trigger signal 125 to the vector network analyzer 20, which initiates a measurement sweep 320. The method comprises looping back to detecting S123 the auxiliary trigger signal 265. If the outcome is negative (*N*), i.e. if more than a background sweep 310 has been performed, the determining S130 is complete. In this case, the method may comprise sending S134 a suitable notification to a software. The software can then provide a retrieval of the trace data from the vector network analyzer 20, as well as of the measured DC data from the memory 150, and, if needed, initiate another cycle.

While each embodiment may stand on its own as a separate example, it is to be noted that in other embodiments the defined features can be combined differently, i.e. a particular feature described in one embodiment may also be realized in other embodiments.

### List of reference signs

- 10: electronic device
- 20: vector network analyzer
- 21: pulse out x
- 22: pulse out y
- 23: measurement trigger in port
- 24: measurement trigger ready port
- 25: auxiliary trigger in port
- 26: auxiliary trigger ready port
- 30: user interface device
- 35: local area network connection
- 40: pulse modulator
- 45: exterior voltage source
- 100: apparatus
- 103: digital signal controller
- 110: device controller
- 111: current connection
- 112: analog access interface
- 115: current and voltage connections
- 120: analyzer controller
- 121: analog-to-digital converter
- 122: trigger interface
- 125: test trigger signal
- 130: determination controller
- 132: power/control connection
- 142: USB connection
- 150: memory
- 230: measurement trigger in level
- 240: measurement trigger ready level
- 245: measurement trigger signal
- 250: auxiliary trigger in level
- 255: auxiliary trigger signal
- 260: auxiliary trigger out level
- 265: auxiliary trigger signal
- 300: data acquisition
- 305: frequency increase
- 310: background sweep
- 320: measurement sweep
- 400: electronic device command line
- 410: setting a state/frequency
- 500: data acquisition
- 505: pulse
- 510: measurement
- 600: frequency point
- 800: device pulse current
- 805: pulse
- 811, 812, 813: sampling points
- t1, t2,: instances
- S110, S112,: method steps

## Claims

1. An apparatus (100) for determining parameters of an electronic device (10) by means of a vector network analyzer (20), wherein the electronic device (10) is designed for a radar system and configured to be set in any one of a plurality of states, and wherein the vector network analyzer (20) is configured to run a test of the electronic device (10), the apparatus (100) comprising:
a device controller (no), configured to set a state of the electronic device (10);
an analyzer controller (120), configured to send to the vector network analyzer (20) a test trigger signal (125) for triggering the test of the electronic device (10); and
a determination controller (130), configured to determine the parameters based on setting the state of the electronic device (10), and on triggering the test of the electronic device (10).

2. The apparatus (100) according to claim 1, wherein the determination controller (130) is configured to determine the parameters based on running a sequence of tests.

3. The apparatus (100) according to any one of the preceding claims, wherein the apparatus (100) is configured to be connected to a user interface device (30), and wherein the determination controller (130) is configured to receive from the user interface device (30) an initiation signal in order to determine the parameters.

4. The apparatus (100) according to any one of the preceding claims, wherein the electronic device (10) is one of the following:
- a power amplifier,
- a low-noise amplifier
- an electronic attenuator
- a phase shifter
- a duplexer,
- a transmission and/or reception module.

5. The apparatus (100) according to any one of the preceding claims, wherein the analyzer controller (120) is configured to adapt the test trigger signal (125) to trigger at least one of the following:
- a point test (510), wherein the vector network analyzer (20) runs a test **characterized by** one particular AC current frequency and/or power,
- a sweep test (320), wherein the vector network analyzer (20) runs a test **characterized by** a particular range of AC current frequencies and/or power.

6. The apparatus (100) according to any one of the preceding claims, wherein the analyzer controller (120) is configured to one or more of the following:
- to send to the vector network analyzer (20) a setup information for the test,
- to send to the vector network analyzer (20) a signal (125, 255) for interrupting and/or resuming the running test,
- to receive from the vector network analyzer (20) a signal (245, 265) if the vector network analyzer (20) is ready to run the test,
- to receive from the vector network analyzer (20) a status information about the running test,
- to receive from the vector network analyzer (20) a confirmation signal for confirming that the vector network analyzer (20) has terminated running the test,
- to receive from the vector network analyzer (20) result data after the vector network analyzer (20) has terminated running the test.

7. The apparatus (100) according to any one of the preceding claims, wherein the analyzer controller (120) is configured to receive an analog electric pulse (805), to perform a sampling of the pulse (805), and to store data obtained from sampling of the pulse (805).

8. The apparatus (100) according to any one of the preceding claims, wherein for the test, an analog electric pulse (805) is provided to the electronic device (10), and wherein the device controller (no) is configured to modulate the pulse (805) provided to the electronic device (10).

9. The apparatus (100) according to any one of the preceding claims, wherein the apparatus (100) is configured for measuring a direct current parameter of the electronic device (10).

10. The apparatus (100) according to any one of the preceding claims, wherein the analyzer controller (120) is configured to initiate a calibration (310) of the vector network analyzer (20).

11. The apparatus (100) according to any one of the preceding claims, wherein the determination controller (130) is configured to detect a type of the electronic device (10).

12. The apparatus (100) according to any one of the preceding claims, wherein the apparatus (100) includes a user interface for a user to set the state of the electronic device (10).

13. A testing system for determining parameters of an electronic device (10), wherein the electronic device (10) is designed for a radar system and configured to be set in any one of a plurality of states, the testing system comprising:
a vector network analyzer (20), configured to run a test of the electronic device (10);
an apparatus (100) according to any one of the preceding claims; and
a user interface device, configured to setup the vector network analyzer (20), and to connect to the apparatus (100).

14. A method for performing a measurement of parameters of an electronic device (10) by means of a vector network analyzer (20), wherein the electronic device (10) is designed for a radar system and configured to be set in any one of a plurality of states, and wherein the vector network analyzer (20) is configured to run a test of the electronic device (10), the method comprising:
setting (S110) a state of the electronic device (10);
sending (S120) to the vector network analyzer (20) a test trigger signal (125) configured to trigger the test of the electronic device (10); and
determining (S130) the parameters based on setting the state of the electronic device (10), and on triggering the test of the electronic device (10).
